# EUROPEAN PATENT APPLICATION

(11) **EP 4 823 259 A1**
(43) Date of publication of application: **14.10.2026**
(21) Application number: 26161647.8
(22) Date of filing: 02.03.2026
(51) Int. Cl.: H05K 7/20

(54) **THERMAL MANAGEMENT SYSTEM FOR ELECTRONIC ENCLOSURES**

(30) Priority: 31.03.2025 US 202519095952
(71) Applicant: Eaton Intelligent Power Limited, Dublin 4, D04 Y0C2 (IE)
(72) Inventor: Caulfield, Francis Donald, Raleigh (US); Moraes, Keefe Malcolm, Clayton (US)
(74) Representative: Puchberger & Partner Patentanwälte

(57) **Abstract**

The present disclosure relates to a hybrid cooling system for electronic enclosures that can incorporate both liquid and air-based cooling mechanisms within a single structure. The system can include a thermal transfer assembly that facilitates heat transfer between liquid-cooled and aircooled components, allowing for efficient thermal regulation across multiple heat-generating components with different cooling requirements. The thermal transfer assembly can include a thermally conductive plate, which can be fluidly associated with a coolant medium, and a set of heat-absorbing elements that can extend into an enclosed volume. The system can be configured to dissipate heat from a first heat-generating component through direct thermal coupling with the thermally conductive plate while transferring heat from a second heat-generating component positioned within the enclosed volume.

## Description

### FIELD

The present disclosure generally relates to thermal management systems for electronic components and, more particularly, to cooling techniques for power electronics and other heat-generating components housed within or proximate to sealed or semi-sealed enclosures.

### BACKGROUND

Electronic systems and power equipment generate heat during operation, which, if not properly managed, can degrade performance, reduce efficiency, and shorten operational lifespan. Various cooling methodologies have been employed across different applications, including air cooling, liquid cooling, phase-change cooling, and hybrid cooling approaches. The selection of a thermal management strategy depends on multiple factors, such as thermal conductivity, heat dissipation efficiency, enclosure constraints, environmental conditions, and reliability requirements.

In sealed or semi-sealed electronic enclosures, managing heat dissipation presents unique challenges, particularly when external airflow is restricted or when components must be protected from contaminants, moisture, or harsh environmental conditions. Thermal management solutions for such enclosures may incorporate passive or active cooling techniques, utilizing conduction, convection, and phase-change heat transfer principles. Common approaches include heat sinks, liquid cooling plates, thermoelectric cooling, heat exchangers, and airflow circulation systems to regulate internal temperatures.

### SUMMARY

Certain illustrative examples are described in the following numbered clauses:
Clause 1. A cooling system for an electronic assembly, comprising:
   a thermal transfer assembly, the thermal transfer assembly comprising:
   a thermal transfer plate configured to absorb heat from a first heat-generating component, the thermal transfer plate having a first surface for thermal coupling with the first heat-generating component and a second surface opposite the first surface;
   a set of heat-absorbing elements positioned proximate to the second surface of the thermal transfer plate and extending within a sealed housing enclosing an enclosed volume, the set of heat-absorbing elements configured to absorb heat from an environment of the enclosed volume; and
   an internal flow channel thermally associated with the set of heat-absorbing elements, the internal flow channel having a fluid inlet and a fluid outlet and being configured to permit passage of a coolant medium to transfer heat away from the set of heat-absorbing elements.
Clause 2. The cooling system of any of the preceding clauses, wherein the set of heat-absorbing elements comprises a plurality of thermally conductive structures, the plurality of thermally conductive structures being spaced apart from one another to define gaps between adjacent structures.
Clause 3. The cooling system of Clause 2, wherein at least a portion of the plurality of thermally conductive structures define a hollow internal cavity, the hollow internal cavity extending within each respective thermally conductive structure and being fluidly connected to the internal flow channel.
Clause 4. The cooling system of any of the preceding clauses, wherein the set of heat-absorbing elements comprises a continuous fin array, the continuous fin array including multiple alternating ridges and troughs extending along a length of the continuous fin array, and wherein the internal flow channel is arranged in a serpentine path in alignment with the continuous fin array.
Clause 5. The cooling system of Clause 4, wherein the continuous fin array comprises a plurality of parallel segments, each segment being spaced apart from an adjacent segment to define a generally uniform heat exchange pathway.
Clause 6. The cooling system of any of the preceding clauses, wherein the set of heat-absorbing elements includes a plurality of thermally conductive structures, the plurality of thermally conductive structures being arranged in a radial configuration relative to the thermal transfer plate.
Clause 7. The cooling system of Clause 6, wherein the plurality of thermally conductive structures includes structures of differing lengths, the differing lengths varying across the radial configuration relative to the thermal transfer plate.
Clause 8. The cooling system of any of the preceding clauses, wherein the sealed housing is configured to enclose a second heat-generating component within the enclosed volume, an environment of the enclosed volume being in thermal communication with the set of heat-absorbing elements to facilitate heat transfer from the second heat-generating component to the coolant medium circulating through the internal flow channel.
Clause 9. The cooling system of any of the preceding clauses, further comprising an air movement device positioned within the enclosed volume, the air movement device being configured to induce convective airflow across the set of heat-absorbing elements to facilitate heat transfer from a second heat-generating component within the enclosed volume to the coolant medium.
Clause 10. The cooling system of any of the preceding clauses, wherein the first heat-generating component is positioned external to the sealed housing, exposed to an external environment.
Clause 11. The cooling system of any of the preceding clauses, wherein the thermal transfer plate is structurally integrated with the sealed housing such that the thermal transfer plate forms at least a portion of a boundary wall of the enclosed volume.
Clause 12. The cooling system of any of the preceding clauses, wherein the sealed housing is an independent, self-contained enclosure configured to maintain an internal gas volume substantially isolated from an external atmosphere and restrict fluid exchange with the external atmosphere.
Clause 13. The cooling system of any of the preceding clauses, wherein at least one of the fluid inlet or the fluid outlet is positioned at the thermal transfer plate, and wherein at least a portion of the internal flow channel extends through at least a portion of the thermal transfer plate, thereby transferring heat away from the thermal transfer plate.
Clause 14. The cooling system of any of the preceding clauses, wherein each of the set of heat-absorbing elements comprises an elongated thermally conductive body extending in a predetermined direction.
Clause 15. The cooling system of any of the preceding clauses, wherein the first heat-generating component is positioned within a separate sealed enclosure, the separate sealed enclosure being structurally distinct from the sealed housing and defining an isolated internal volume.
Clause 16. The cooling system of any of the preceding clauses, further comprising:
   the first heat-generating component disposed on the first surface of the thermal transfer plate;
   the sealed housing; and
   a second heat-generating component disposed within the sealed housing.
Clause 17. A thermal transfer assembly comprising:
   thermal transfer plate configured to absorb heat from a first heat-generating component, the thermal transfer plate having a first surface for thermal coupling with the first heat-generating component and a second surface opposite the first surface;
   a set of heat-absorbing elements positioned proximate to the second surface of the thermal transfer plate and configured to be disposed within a sealed housing that encloses an enclosed volume, the set of heat-absorbing elements configured to absorb heat from an environment of the enclosed volume; and
   an internal flow channel thermally associated with the set of heat-absorbing elements, the internal flow channel having a fluid inlet and a fluid outlet and being configured to permit passage of a coolant medium to transfer heat away from the set of heat-absorbing elements.
Clause 18. The thermal transfer assembly of Clause 17, wherein the set of heat-absorbing elements comprises a continuous fin array, the continuous fin array including multiple alternating ridges and troughs extending along a length of the continuous fin array, and wherein the internal flow channel is arranged in a serpentine path in alignment with the continuous fin array.
Clause 19. The thermal transfer assembly of Clause 17, wherein the thermal transfer plate is configured to be disposed in structural integration with the sealed housing such that the thermal transfer plate forms at least a portion of a boundary wall of the enclosed volume.
Clause 20. A sealed cooling enclosure, comprising:
   a housing defining an enclosed volume;
   a thermal transfer plate positioned to form at least a portion of a boundary of the enclosed volume, the thermal transfer plate having a first surface facing outward from the enclosed volume and configured to thermally couple with a heat-generating component, and a second surface opposite the first surface and facing inward toward the enclosed volume;
   a continuous fin array coupled to the thermal transfer plate and disposed within the enclosed volume, the continuous fin array including a series of alternating ridges and troughs extending along a length of the continuous fin array, wherein the continuous fin array is configured to absorb heat from an environment of the enclosed volume; and
   an internal flow channel defined at least in part by a hollow internal cavity of the continuous fin array, the internal flow channel being configured to direct a coolant medium through the continuous fin array to transfer heat away from the continuous fin array.

### BRIEF DESCRIPTION OF THE DRAWINGS

Throughout the drawings, reference numbers can be re-used to indicate correspondence between referenced elements. The drawings are provided to illustrate embodiments of the present disclosure and do not to limit the scope thereof.
FIG. 1 illustrates an example thermal management system.
FIGS. 2A-2C illustrate example thermal transfer assemblies.
FIG. 3 illustrates an example thermal management system
FIG. 4 illustrates an example thermal management system.

### DETAILED DESCRIPTION

Many electronic systems generate heat during operation, and managing this heat can help maintain performance and longevity. In various environments, additional challenges arise from factors such as dust, moisture, airborne contaminants, and other environmental conditions. For example, outdoor equipment may be exposed to rain, dust, and temperature extremes, while enclosed spaces like subway stations present risks from metallic brake dust and other pollutants. Enclosures can provide protection, but they may also influence how cooling systems are designed and integrated.

Power electronics, such as inverters, often include different types of components with varying cooling needs. For example, high-power semiconductor devices, such as IGBT modules, tend to generate more heat, while other components, such as capacitors and bus structures, generate less heat but may still require some level of cooling. In some cases, certain components may be enclosed for environmental protection, while others may remain outside the enclosure. Balancing these needs in a way that manages heat effectively while keeping the overall system footprint reasonable can be an important design consideration.

To address these or other challenges, some inventive concepts described herein relate to a cooling system that manages heat transfer between components with different power levels and environmental requirements. In some cases, certain components may need to be enclosed to protect them from dust, moisture, or other environmental conditions, while higher-power components may be positioned outside the enclosure if they can withstand exposure. This setup allows for a more flexible design, reducing the need for enclosures where they are not necessary, while still providing effective cooling for enclosed components.

In some cases, managing heat inside an enclosure can be more challenging than in open environments, as airflow may be more restricted. To address this, some inventive concepts described herein relate to a thermal transfer assembly that integrates both liquid cooling and air-based heat absorption in a single structure. The thermal transfer assembly can include a thermal transfer plate with a first side configured to receive and thermally couple to a first heat-generating component, which can operate in an exposed environment. On the opposite side of the thermal transfer plate, the assembly can include a set of heat-absorbing elements that extend into a sealed enclosure that includes a second heat-generating component, which may be enclosed to limit exposure to environmental conditions. In this way, the thermal transfer assembly can facilitate heat transfer for both enclosed and exposed components, allowing for efficient thermal management across the thermal transfer assembly while maintaining a compact footprint. The thermal transfer assembly can further include an internal flow channel thermally associated with the heat-absorbing elements to allow a coolant medium to flow through the thermal transfer assembly. This coolant flow path can follow a serpentine route or other alternative flow patterns, such as parallel or branched configurations. This coolant flow path enables heat transfer away from the heat-absorbing elements, improving thermal regulation within the enclosure while, in some cases, also dissipating heat from unenclosed components. By integrating these cooling functions, the system can support an efficient use of space and offer flexibility in system design and layout.

In some cases, the set of heat-absorbing elements can include fins or other thermally conductive structures that can transfer heat from the environment within the enclosure to a coolant medium. The heat-absorbing elements can be arranged as a continuous fin array or as a series of discrete heat-exchanging structures. In contrast to traditional cooling systems that integrate fins to dissipate heat-such as in a heat sink, which can transfer heat from a solid component to the surrounding air, or a radiator, which can transfer heat from a liquid coolant to the air-the fins disclosed herein can be configured to absorb heat from the environment inside the enclosure and transfer it into a coolant medium flowing through an internal flow channel.

The heat-absorbing elements can be thermally associated with the thermal transfer plate and positioned to facilitate heat transfer between the enclosure environment and the coolant medium. In some cases, the heat-absorbing elements can include a hollow internal cavity that defines at least a portion of the internal flow channel, allowing coolant to flow directly through them. When fins are used, the internal flow channel can follow a serpentine path, enhancing heat transfer by increasing the contact area between the coolant and the heat-absorbing surfaces.

Some inventive concepts described herein relate to a cooling system that includes a sealed housing that defines a chamber, within which at least one second heat-generating component can be positioned. The chamber can be thermally associated with the heat-absorbing elements, allowing heat from the second heat-generating component to be transferred to the coolant medium circulating through the internal flow channel. The sealed housing can provide protection from environmental exposure, limiting ingress of dust, moisture, or other contaminants that could affect sensitive electrical components. In some implementations, the sealed housing can be an independent, self-contained enclosure, where the internal gas volume remains substantially isolated from the external atmosphere

Some inventive concepts described herein relate to the arrangement of heat-absorbing elements positioned adjacent to one another in a spaced configuration. The heat-absorbing elements can be elongated thermally conductive structures, each extending in a predetermined direction to facilitate heat transfer from the enclosure environment to the coolant medium. In some cases, gaps or spacing between adjacent heat-absorbing elements can allow for airflow circulation within the enclosure, enabling heat to be transferred from multiple locations while maintaining convective airflow pathways. In some implementations, an internal flow channel can be thermally associated with each heat-absorbing element.

Some inventive concepts described herein relate to the arrangement of the heat-absorbing elements as a continuous fin array, which can provide an extended surface area for thermal exchange. The continuous fin array can include alternating ridges and troughs, which can increase the surface area exposed to the air within the enclosure while also forming structured pathways for coolant flow. In some cases, the internal flow channel can follow a serpentine path within the continuous fin array, allowing for increased thermal interaction between the coolant medium and the heat-absorbing surfaces.

Some inventive concepts described herein relate to the inclusion of a sealed housing to enclose certain heat-generating components while maintaining efficient thermal regulation. The sealed housing can define a chamber that thermally interacts with the heat-absorbing elements, allowing heat from enclosed components to be transferred to the coolant medium circulating through the internal flow channel. In some implementations, the sealed housing can be configured as an independent, self-contained enclosure, maintaining an internal gas volume that is substantially isolated from the external atmosphere to provide protection against dust, moisture, or other environmental contaminants.

Some inventive concepts described herein relate to the structural integration of the thermal transfer plate with a chamber, allowing the thermal transfer plate to form at least a portion of a boundary wall of the chamber. Such an integration can allow the thermal transfer plate to function both as a heat dissipation structure and as a mechanical barrier within the system.

Some inventive concepts described herein relate to the adaptability of the cooling system to accommodate multiple heat-generating components in different physical configurations. The system can be designed to allow the first heat-generating component to be positioned external to the sealed housing, exposed to the external environment, while the second heat-generating component is enclosed within the housing. In some cases, the system can incorporate both air-based and liquid-based cooling within a single structure, allowing different thermal management strategies to be applied to different components depending on their cooling requirements. The hybrid nature of the system can facilitate flexible thermal regulation by combining conductive, convective, and liquid cooling mechanisms to transfer heat across enclosed and external environments. This configuration can allow for efficient heat dissipation while providing environmental protection for sensitive components.

### Example Thermal Management System

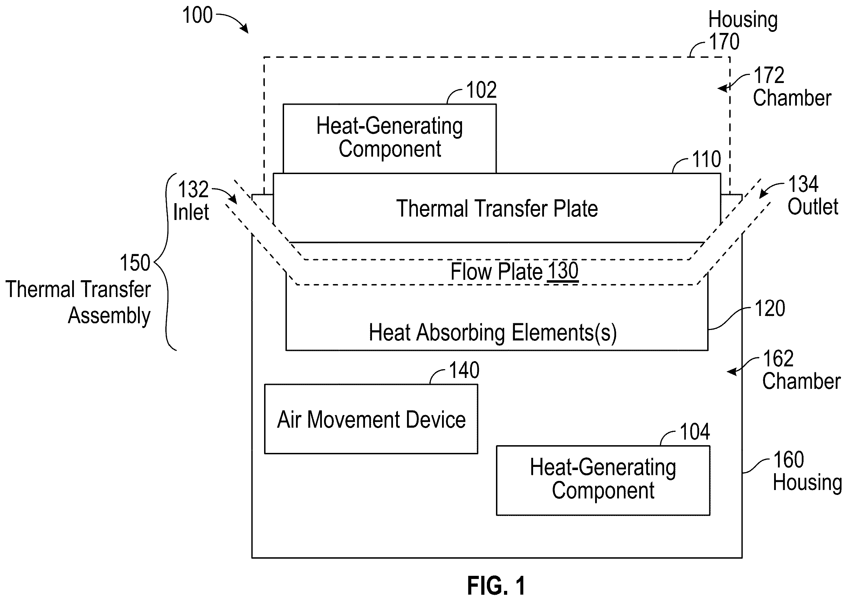

FIG. 1 illustrates an example thermal management system 100. The thermal management system 100 includes thermal transfer assembly 150, heat-generating components 102, 104, and an air movement device 140. It will be appreciated that the thermal management system 100 may include fewer, different, or additional components, depending on the embodiment. For example, in some cases, the air movement device 140 may be excluded.

The thermal transfer assembly 150 can facilitate heat movement between different thermal environments by employing one or more heat dissipation mechanisms, such as conduction, convection, and/or liquid cooling. By establishing a thermal pathway between regions with differing temperatures, the thermal transfer assembly 150 can direct heat away from heat-generating components, reducing localized temperature buildup. In some cases, the thermal transfer assembly 150 can function as part of a sealed or semi-sealed system, forming at least a portion of a housing wall that separates a chamber 162 from an external environment or another chamber 172. This arrangement can allow heat to be transferred without exposing internal components (e.g., the heat-generating component 104) to external contaminants or environmental conditions. The thermal transfer assembly 150 can be thermally associated with components positioned within the chamber 162, outside of it, or in both locations, providing flexibility in system design. In some cases, the thermal transfer assembly 150 integrates multiple cooling functions within a compact structure, reducing a need for additional external heat exchangers and facilitating efficient thermal management in space-constrained applications.

The thermal transfer assembly 150 can include a thermal transfer plate 110, a set of heat absorbing elements 120, and/or a flow channel 130. The thermal transfer plate 110 can be configured to transfer heat from one or more thermally associated components, providing a pathway for heat to be directed toward other cooling structures within the thermal transfer assembly 150. The thermal transfer plate 110 can be thermally coupled to a heat-generating component 102 through direct contact or an intermediary thermal interface, depending on system requirements. In some cases, the thermal transfer plate 110 can be fluidly associated with a cooling medium, allowing heat to be carried away by liquid coolant flowing through an adjacent or integrated channel (e.g., the flow channel 130). In some cases, the thermal transfer plate 110 can be arranged to transfer heat to air-cooled elements, such as fins or heat exchangers, to facilitate dissipation through convection.

The thermal transfer plate 110 can be positioned within a larger housing 160 or enclosure. In some cases, the thermal transfer plate 110 can be integrated into an enclosure wall or other structural element, where the thermal transfer plate 110 may contribute to thermal and/or mechanical functions. In some configurations, the thermal transfer plate 110 may be implemented as a cold plate, configured for liquid cooling applications. The specific geometry, material composition, or surface characteristics of the thermal transfer plate 110 can vary depending on the thermal management strategy, environmental conditions, and space constraints of a given implementation.

The set of heat-absorbing elements 120 can be thermally associated with the thermal transfer plate 110 and can be positioned to receive heat from the chamber 162. The set of heat-absorbing elements 120 can be arranged in various configurations to facilitate heat transfer, including spaced-apart structures, continuous fin arrays, or other thermally conductive geometries. In some implementations, the set of heat-absorbing elements 120 can extend into the chamber 162, where they can absorb heat produced by internal components, such as the heat-generating component 104, and direct the heat toward other cooling structures within the thermal transfer assembly 150.

The number, shape, orientation, and/or spacing of the set of heat-absorbing elements 120 can vary depending on thermal requirements and spatial constraints. In some cases, the set of heat-absorbing elements 120 can be arranged as a series of parallel fins extending from the thermal transfer plate 110, for example to increase surface area for heat absorption. In some cases, the set of heat-absorbing elements 120 can be configured in a radial pattern, with structures extending outward from a generally central region to facilitate multi-directional heat transfer. In some implementations, the set of heat-absorbing elements 120 can include staggered or irregularly spaced structures to promote airflow mixing and reduce thermal resistance. In some cases, the set of heat-absorbing elements 120 can form a fractal or branching geometry, facilitating increased heat absorption within a compact footprint. In some cases, the set of heat-absorbing elements 120 can be configured with tapered or varying-length structures to accommodate localized heat sources and airflow patterns. In some cases, the set of heat-absorbing elements 120 can be manufactured using additive manufacturing techniques, allowing complex geometries that enhance thermal performance while maintaining a compact design.

Unlike traditional heat-dissipating structures that transfer heat from a solid component to the surrounding air, the set of heat-absorbing elements 120 can be configured to absorb heat directly from the environment within the chamber 162 and transfer it into a coolant medium flowing through the flow channel 130. Such an arrangement can allow for effective thermal management in sealed or semi-sealed enclosures where external airflow is restricted. Thus, for example, in cases where the set of heat-absorbing elements 120 is implemented as fins, the fins can function in contrast to traditional heat sink fins that dissipate heat into the surrounding air. Instead, they are positioned to absorb heat from the enclosed environment and transfer it into a cooling medium, facilitating indirect heat removal from the second heat-generating component 104.

In some cases, the set of heat-absorbing elements 120 can include hollow structures defining an internal flow channel (e.g., the flow channel 130), allowing a coolant medium to circulate and transfer heat away from the chamber 162. In some cases, the set of heat-absorbing elements 120 can be solid thermally conductive structures, configured to transfer heat via conduction to adjacent cooling components, such as an adjacent flow channel 130.

The flow channel 130 can be configured to direct a coolant medium through the thermal transfer assembly 150, facilitating heat transfer between thermally associated components. The flow channel 130 can be positioned to receive heat from the thermal transfer plate 110, the set of heat-absorbing elements 120, or both, depending on the cooling configuration. The flow channel 130 can include an inlet 132 and an outlet 134, allowing coolant to enter, absorb heat, and exit, carrying thermal energy away from the system. In some cases, the flow channel 130 can be fluidly connected to an external cooling loop, enabling integration with broader thermal management systems. The placement of the inlet 132 and the outlet 134 can vary depending on system constraints and cooling requirements. In some implementations, at least one of the inlet 132 or the outlet 134 is positioned at the thermal transfer plate 110.

The flow channel 130 can be defined by various structures depending on the system design. In some cases, the flow channel 130 can be an at least partially internal passage within a thermally conductive structure, such as a channel embedded within the thermal transfer plate 110 and/or the set of heat absorbing elements 120. In some cases, at least part of the flow channel 130 can be a separate conduit positioned adjacent to the thermal transfer plate 110 and/or the set of heat absorbing elements 120. The geometry of the flow channel 130 can vary to accommodate different thermal and flow requirements. In some cases, the flow channel 130 can follow a straight or minimally obstructed path to reduce flow resistance and pressure drop. In some cases, the flow channel 130 can have a serpentine, branched, or multi-path configuration to increase coolant residence time and increase heat absorption.

A coolant can be a fluid medium circulated through the flow channel 130 to transfer heat away from thermally associated components. The coolant can be selected based on factors such as thermal conductivity, specific heat capacity, operating temperature range, and compatibility with system materials. In some cases, the coolant can be a liquid, such as water, water-glycol mixtures, dielectric fluids, or specialized heat transfer fluids designed for high-temperature or electrically insulating applications. In some cases, the coolant can be a gas, such as air, nitrogen, or a refrigerant, depending on the cooling method employed. The coolant can operate within a broad range of temperatures, depending on the thermal management requirements of the system. Similarly, the flow rate, pressure, and phase of the coolant can be adjusted based on system constraints.

The first heat-generating component 102 and the second heat-generating component 104 can generate heat during operation, requiring thermal management to maintain performance and reliability. These components can include, but are not limited to, electronic, electrical, or mechanical devices that dissipate heat as a byproduct of power conversion, signal processing, or other operational functions.

The first heat-generating component 102 can be a relatively high-power component that may be positioned outside an enclosure, such as the housing 160, or within an enclosure, such as the housing 170. In some cases, the first heat-generating component 102 can be thermally coupled to the thermal transfer plate 110, allowing heat to be transferred into the flow channel 130 for removal via liquid cooling. Compared to the second heat-generating component 104, the first heat-generating component 102 can be relatively more resistant to environmental factors, including dust, moisture, and temperature fluctuations. In some cases, the first heat-generating component 102 can be positioned outside, exposed to external conditions, without requiring additional environmental protection. In some cases, the first heat-generating component 102 can be enclosed within the housing 170 or the housing 160. Examples of the first heat-generating component 102 can include, but are not limited to, high-power semiconductor devices such as insulated-gate bipolar transistors (IGBTs), power modules, voltage regulators, transformers, or other heat-generating electronics used in power conversion, motor drives, or industrial control systems.

The second heat-generating component 104 can be a relatively low-power component positioned within the chamber 162, such as within housing 160, and thermally associated with the set of heat-absorbing elements 120. In some implementations, as compared to the first heat-generating component 102, the second heat-generating component 104 can be more sensitive to environmental exposure and may require protection from dust, moisture, or other contaminants. The second heat-generating component 104 can transfer heat indirectly, with heat absorbed by the surrounding air and directed toward the set of heat-absorbing elements 120, which then facilitate heat transfer to the thermal transfer plate 110 or an associated cooling medium. Examples of the second heat-generating component 104 can include, but are not limited to, capacitors, inductors, control circuits, low-power switching elements, or other components that produce heat during electrical operation.

The air movement device 140 can be configured to facilitate airflow within the housing 160, promoting heat transfer from the second heat-generating component(s) 104 to the set of heat-absorbing elements 120. The air movement device 140 can include, but is not limited to, a fan, stirrer fan, blower, impeller, or other airflow-inducing mechanism capable of circulating air within the enclosure. In some cases, the air movement device 140 can be positioned to direct airflow across the set of heat-absorbing elements 120, improving heat absorption by increasing convective heat transfer.

The air movement device 140 can operate in various configurations depending on the cooling strategy employed. In some implementations, the air movement device 140 can be configured to create a forced airflow pathway, guiding heated air from the second heat-generating component 104 toward the set of heat-absorbing elements 120. In some implementations, the air movement device 140 can be used to mix air within the housing 160, limiting localized heat buildup and maintaining a more uniform temperature distribution. The air movement device 140 can be arranged in proximity to thermally significant components and may operate continuously or intermittently based on thermal load conditions. The size, speed, and placement of the air movement device 140 can be adjusted based on factors such as enclosure size, component heat dissipation, and system airflow requirements.

The housing 160 can define the chamber 162 that includes at least one second heat-generating component 104 and can be configured to provide environmental protection, thermal regulation, or structural support. The housing 160 can serve as a barrier to isolate internal components from external contaminants such as dust, moisture, or debris, while also influencing airflow and heat dissipation characteristics within the housing 160. In some cases, the housing 160 can be sealed to limit fluid exchange with the external environment, while in other cases, the housing 160 can include ventilation features, such as controlled airflow pathways, to facilitate cooling.

The housing 170 can define an enclosed or partially chamber 172 that contains the first heat-generating component 102 and can provide structural support, environmental protection, or thermal management functionality. In some cases, the housing 170 can serve as a protective enclosure, shielding the first heat-generating component 102 from dust, moisture, and other environmental factors while still allowing for effective heat dissipation. In other cases, the housing 170 can be configured to permit airflow or direct thermal coupling to external cooling structures, depending on the thermal management strategy employed. In some implementations, the housing 170 and the housing 160 can be the same structure, enclosing both the first heat-generating component 102 and the second heat-generating component 104 within a shared volume. In some cases, the housing 170 may not be included as part of the thermal management system 100, and the first heat-generating component 102 can be open to the external environment. In some such implementations, the first heat-generating component 102 can be positioned to dissipate heat directly into ambient air or be thermally coupled to external cooling structures to facilitate heat removal.

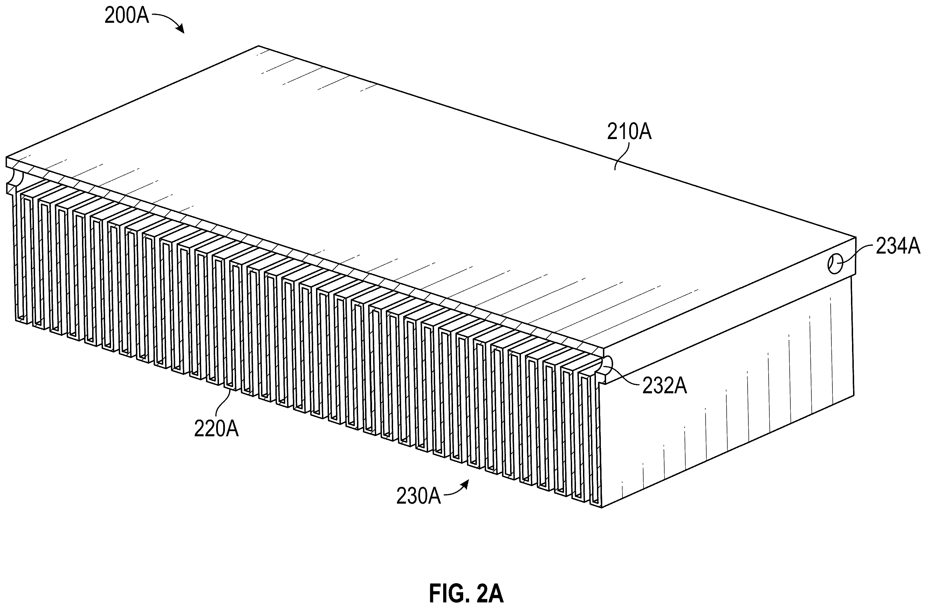

FIGS. 2A-2C illustrate example thermal transfer assemblies 200A, 200B, and 200C, which may be embodiments of the thermal transfer assembly 150 of FIG. 1. Each thermal transfer assembly 200A, 200B, and 200C includes a thermal transfer plate 210A, 210B, 210C, a set of heat-absorbing elements 220A, 220B, 220C, and a flow channel (not shown) for circulating a coolant medium. The flow channel includes an inlet 232A, 232B, 232C and an outlet 234A, 234B, 234C, allowing coolant to flow through the thermal transfer assembly 200A, 200B, 200C to facilitate heat transfer. The thermal transfer plate 210A, 210B, 210C is configured to receive heat from a thermally associated heat-generating component (not shown) and transfer the heat to the coolant medium flowing through the internal flow channel. The set of heat-absorbing elements 220A, 220B, 220C also facilitate heat transfer to the coolant medium, improving overall thermal management.

FIG. 2A illustrates a thermal transfer assembly 200A that includes a set of heat-absorbing elements 220A arranged as a plurality of parallel fins extending perpendicularly from the thermal transfer plate 210A. The heat-absorbing elements 220A can be evenly spaced along the length and width of the thermal transfer plate 210A, defining uniform gaps between adjacent elements. The fins can have a generally rectangular cross-section, with a consistent thickness extending along their height. The heat-absorbing elements 220A can be integrally formed with the thermal transfer plate 210A or affixed using bonding, mechanical fasteners, or other attachment methods. The length, width, and height of the heat-absorbing elements 220A can be varied to accommodate different spatial constraints or structural requirements.

Airflow and coolant flow through the thermal transfer assembly can follow different flow patterns depending on the embodiment. In some cases, coolant may enter through inlet 232A and travel along a flow channel within the thermal transfer plate 210A, following a generally linear path across the assembly. From this flow path, branched channels can extend into the heat-absorbing elements 220A, allowing coolant to distribute through the fin structure. This branching configuration may allow heat to be transferred from the heat-absorbing elements to the coolant. The coolant may then reconverge within the flow channel and exit through outlet 234A. In some cases, the coolant flow path may follow a serpentine route, where the coolant moves in a winding pattern dictated by the structure of the heat-absorbing elements 220A. The fins or channels may be arranged to direct coolant along a curved or undulating path, increasing the contact area between the coolant and the thermally conductive surfaces. This extended path can enhance thermal interaction, allowing more heat to be absorbed before the coolant exits the system. In some cases, the coolant flow may follow a parallel arrangement, where multiple flow channels extend uniformly through the heat-absorbing elements 220A. This configuration allows coolant to flow simultaneously through separate but spaced paths, providing consistent heat extraction and reducing temperature gradients across the assembly. In some cases, a branched configuration may be used, where the coolant initially moves along a generally straight path within the thermal transfer plate 210A before splitting into multiple smaller channels that extend outward through the heat-absorbing elements 220A. Such a setup can facilitate coolant distribution, improving thermal regulation while maintaining a compact structure.

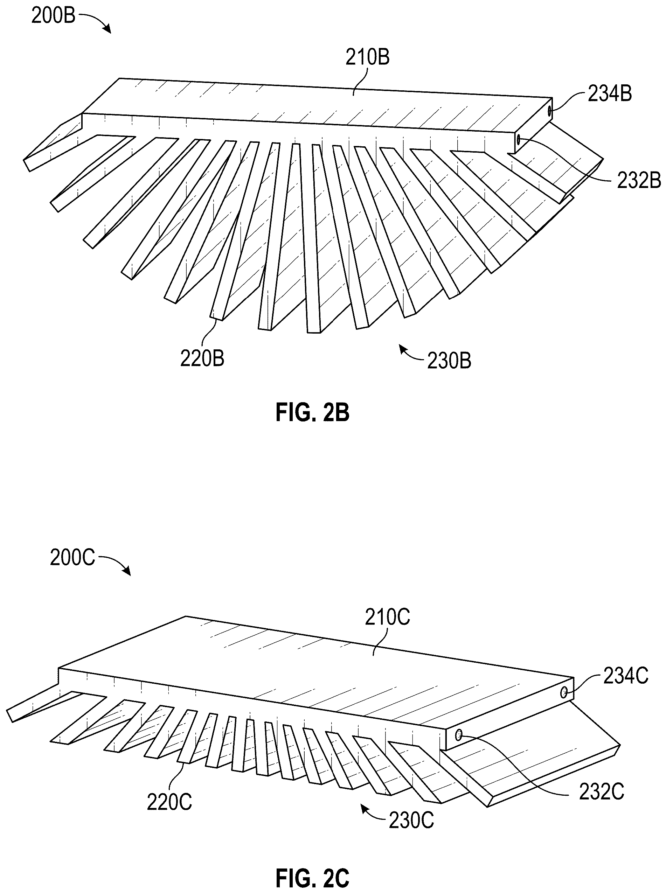

FIG. 2B illustrates a thermal transfer assembly 200B that includes a set of heat-absorbing elements 220B arranged in a radial configuration. The heat-absorbing elements 220B can extend outward from a central region of the thermal transfer plate 210B, with each element positioned at an angle relative to an adjacent element. The heat-absorbing elements 220B can have a generally planar structure, with a consistent width and thickness along their length. The spacing between adjacent heat-absorbing elements 220B can vary along the radial arrangement, with wider gaps at outer edges and narrower spacing near the thermal transfer plate 210B. The elements 220B can be positioned in a fixed orientation relative to the thermal transfer plate 210B, secured through integral formation, bonding, or mechanical fastening.

FIG. 2C illustrates a thermal transfer assembly 200C that includes a set of heat-absorbing elements 220C configured in a non-uniform or tapered arrangement. The heat-absorbing elements 220C can extend outward from the thermal transfer plate 210C, with variations in length, width, and orientation along the surface. The elements 220C can be arranged with irregular spacing, with some elements positioned closer together while others are spaced farther apart. In some cases, the heat-absorbing elements 220C can have a tapered profile, where the width or height gradually decreases along their length. The elements 220C can be secured to the thermal transfer plate 210C through direct integration, bonding, or mechanical attachment, depending on the material composition and manufacturing process.

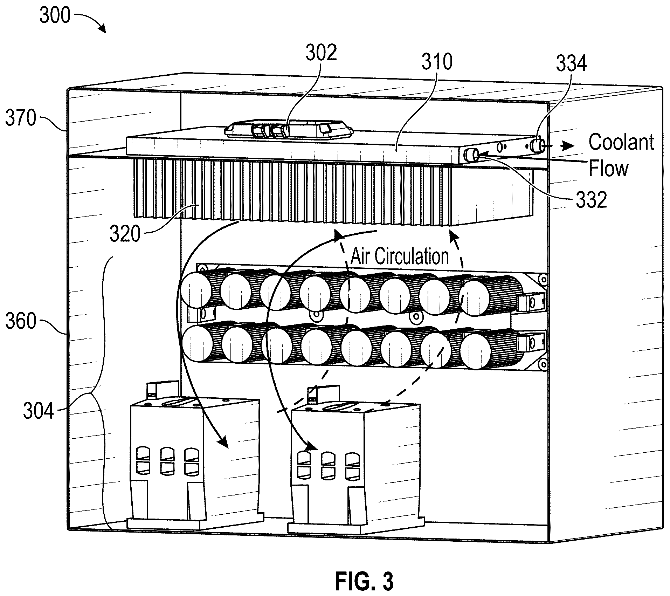

FIG. 3 illustrates an example thermal management system 300, which can be an embodiment of the thermal management system 100 of FIG. 1. The thermal management system 300 includes a first heat-generating component 302, a thermal transfer plate 310, a set of heat-absorbing elements 320, a second heat-generating component 304, a first housing 360, and a second housing 370. The thermal management system 300 further includes an internal flow channel, having a coolant inlet 332 and outlet 334 to facilitate heat transfer. The arrangement shown in FIG. 3 shows passive heat conduction, where the airflow pathway is illustrated with directional arrows, indicating an example airflow pattern within the enclosed volume.

The housing 360 encloses the second heat-generating component 304 and the set of heat-absorbing elements 320, defining an internal chamber where heat exchange occurs. The first heat-generating component 302 is thermally coupled to the thermal transfer plate 310 and positioned in the second housing 370. In some cases, the second housing 370 may be a separate enclosure surrounding the first heat-generating component 302, or the first heat-generating component 302 may be exposed to the external environment.

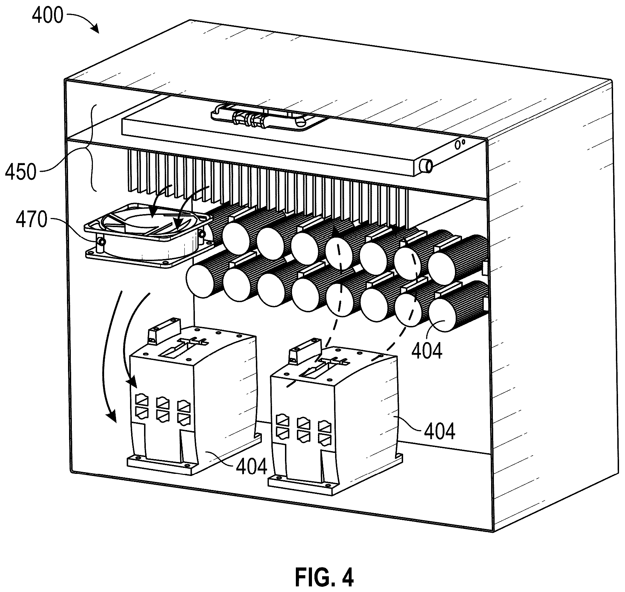

FIG. 4 illustrates an example thermal management system 400, which can be an embodiment of the thermal management system 100, 300 of FIG. 1 and 3, respectively. The thermal management system 400 includes a thermal transfer assembly 450.

FIG. 4 differs from FIG. 3 by depicting an air movement device 470 positioned within the housing and configured to direct airflow within the enclosure. The air movement device 470 can be implemented as a fan, blower, or other airflow-inducing mechanism. In this configuration, the air movement device 470 is positioned adjacent to the set of heat-absorbing elements and can promote airflow circulation within the enclosure. The airflow path, indicated by arrows, guides air across the second heat-generating components 404 and toward the heat-absorbing elements.

### Terminology

It is understood by those skilled in the art that the disclosure extends beyond the specifically disclosed embodiments to other alternative embodiments and/or uses and obvious modifications and equivalents thereof. In addition, while several variations of the embodiments of the disclosure have been shown and described in detail, other modifications, which are within the scope of this disclosure, will be readily apparent to those of skill in the art. It is also contemplated that various combinations or sub-combinations of the specific features and aspects of the embodiments may be made and still fall within the scope of the disclosure. For example, features described above in connection with one embodiment can be used with a different embodiment described herein and the combination still fall within the scope of the disclosure. It should be understood that various features and aspects of the disclosed embodiments can be combined with, or substituted for, one another in order to form varying modes of the embodiments of the disclosure. Thus, it is intended that the scope of the disclosure herein should not be limited by the particular embodiments described above. Accordingly, unless otherwise stated, or unless clearly incompatible, each embodiment of this present disclosure may include, additional to its essential features described herein, one or more features as described herein from each other embodiment of the present disclosure disclosed herein.

Features, materials, characteristics, or groups described in conjunction with a particular aspect, embodiment, or example are to be understood to be applicable to any other aspect, embodiment or example described in this section or elsewhere in this specification unless incompatible therewith. All of the features disclosed in this specification (including any accompanying claims, abstract and drawings), and/or all of the steps of any method or process so disclosed, may be combined in any combination, except combinations where at least some of such features and/or steps are mutually exclusive. The protection is not restricted to the details of any foregoing embodiments. The protection extends to any novel one, or any novel combination, of the features disclosed in this specification (including any accompanying claims, abstract and drawings), or to any novel one, or any novel combination, of the steps of any method or process so disclosed.

Furthermore, features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in various combinations, one or more features from a claimed combination can, in some cases, be excised from the combination, and the combination may be claimed as a subcombination or variation of a sub combination.

Moreover, while operations may be depicted in the drawings or described in the specification in a particular order, such operations need not be performed in the particular order shown or in sequential order, or that all operations be performed, to achieve desirable results. Other operations that are not depicted or described can be incorporated in the example methods and processes. For example, one or more additional operations can be performed before, after, simultaneously, or between any of the described operations. Further, the operations may be rearranged or reordered in other implementations. Those skilled in the art will appreciate that in some cases, the actual steps taken in the processes illustrated and/or disclosed may differ from those shown in the figures. In at least some examples, the steps described above may be removed, others may be added. Furthermore, the features and attributes of the specific embodiments disclosed above may be combined in different ways to form additional embodiments, all of which fall within the scope of the present disclosure. Also, the separation of various system components in the implementations described above should not be understood as requiring such separation in all implementations, and it should be understood that the described components and systems can generally be integrated together in a single product or packaged into multiple products.

For purposes of this disclosure, aspects, advantages, and novel features are described herein. Not necessarily all such advantages may be achieved in accordance with any particular embodiment. Thus, for example, those skilled in the art will recognize that the disclosure may be embodied or carried out in a manner that achieves one advantage or a group of advantages as taught herein without necessarily achieving other advantages as may be taught or suggested herein.

Conditional language, such as "can," "could," "might," or "may," unless specifically stated otherwise, or otherwise understood within the context as used, is generally intended to convey cases include, while other embodiments do not include, features, elements, and/or steps. Thus, such conditional language is not generally intended to imply that features, elements, and/or steps are in any way required for one or more embodiments or that one or more embodiments necessarily include logic for deciding, with or without user input or prompting, whether these features, elements, and/or steps are included or are to be performed in any particular embodiment.

Conjunctive language such as the phrase "at least one of X, Y, and Z," unless specifically stated otherwise, is otherwise understood with the context as used in general to convey that an item, term, etc. may be either X, Y, or Z. Thus, such conjunctive language is not generally intended to imply that certain cases require the presence of at least one of X, at least one of Y, and at least one of Z.

Language of degree used herein, such as the terms "approximately," "about," "generally," and "substantially" as used herein represent a value, amount, or characteristic close to the stated value, amount, or characteristic that still performs a desired function or achieves a desired result. For example, the terms "approximately", "about", "generally," and "substantially" may refer to an amount that is within less than 10% of, within less than 5% of, within less than 1% of, within less than 0.1% of, and within less than 0.01% of the stated amount. As another example, the terms "generally parallel" and "substantially parallel" refer to a value, amount, or characteristic that departs from exactly parallel by less than or equal to 15 degrees, 10 degrees, 5 degrees, 3 degrees, 1 degree, 0.1 degree, or otherwise.

The scope of the present disclosure is not intended to be limited by the specific disclosures of preferred embodiments in this section or elsewhere in this specification, and may be defined by claims as presented in this section or elsewhere in this specification or as presented in the future. The language of the claims is to be interpreted broadly based on the language employed in the claims and not limited to the examples described in the present specification or during the prosecution of the application, which examples are to be construed as non-exclusive.

## Claims

1. A cooling system for an electronic assembly, comprising:
a thermal transfer assembly, the thermal transfer assembly comprising:
a thermal transfer plate configured to absorb heat from a first heat-generating component, the thermal transfer plate having a first surface for thermal coupling with the first heat-generating component and a second surface opposite the first surface;
a set of heat-absorbing elements positioned proximate to the second surface of the thermal transfer plate and extending within a sealed housing enclosing an enclosed volume, the set of heat-absorbing elements configured to absorb heat from an environment of the enclosed volume; and
an internal flow channel thermally associated with the set of heat-absorbing elements, the internal flow channel having a fluid inlet and a fluid outlet and being configured to permit passage of a coolant medium to transfer heat away from the set of heat-absorbing elements.

2. The cooling system of Claim 1, wherein the set of heat-absorbing elements comprises a plurality of thermally conductive structures, the plurality of thermally conductive structures being spaced apart from one another to define gaps between adjacent structures.

3. The cooling system of Claim 2, wherein at least a portion of the plurality of thermally conductive structures define a hollow internal cavity, the hollow internal cavity extending within each respective thermally conductive structure and being fluidly connected to the internal flow channel.

4. The cooling system of Claim 1, wherein the set of heat-absorbing elements comprises a continuous fin array, the continuous fin array including multiple alternating ridges and troughs extending along a length of the continuous fin array, and wherein the internal flow channel is arranged in a serpentine path in alignment with the continuous fin array.

5. The cooling system of Claim 4, wherein the continuous fin array comprises a plurality of parallel segments, each segment being spaced apart from an adjacent segment to define a generally uniform heat exchange pathway.

6. The cooling system of Claim 1, wherein the set of heat-absorbing elements includes a plurality of thermally conductive structures, the plurality of thermally conductive structures being arranged in a radial configuration relative to the thermal transfer plate.

7. The cooling system of Claim 1, wherein the sealed housing is configured to enclose a second heat-generating component within the enclosed volume, an environment of the enclosed volume being in thermal communication with the set of heat-absorbing elements to facilitate heat transfer from the second heat-generating component to the coolant medium circulating through the internal flow channel.

8. The cooling system of Claim 1, further comprising an air movement device positioned within the enclosed volume, the air movement device being configured to induce convective airflow across the set of heat-absorbing elements to facilitate heat transfer from a second heat-generating component within the enclosed volume to the coolant medium.

9. The cooling system of Claim 1, wherein the first heat-generating component is positioned external to the sealed housing, exposed to an external environment.

10. The cooling system of Claim 1, wherein the thermal transfer plate is structurally integrated with the sealed housing such that the thermal transfer plate forms at least a portion of a boundary wall of the enclosed volume.

11. The cooling system of Claim 1, wherein the sealed housing is an independent, self-contained enclosure configured to maintain an internal gas volume substantially isolated from an external atmosphere and restrict fluid exchange with the external atmosphere.

12. The cooling system of Claim 1, wherein at least one of the fluid inlet or the fluid outlet is positioned at the thermal transfer plate, and wherein at least a portion of the internal flow channel extends through at least a portion of the thermal transfer plate, thereby transferring heat away from the thermal transfer plate.

13. A thermal transfer assembly comprising:
thermal transfer plate configured to absorb heat from a first heat-generating component, the thermal transfer plate having a first surface for thermal coupling with the first heat-generating component and a second surface opposite the first surface;
a set of heat-absorbing elements positioned proximate to the second surface of the thermal transfer plate and configured to be disposed within a sealed housing that encloses an enclosed volume, the set of heat-absorbing elements configured to absorb heat from an environment of the enclosed volume; and
an internal flow channel thermally associated with the set of heat-absorbing elements, the internal flow channel having a fluid inlet and a fluid outlet and being configured to permit passage of a coolant medium to transfer heat away from the set of heat-absorbing elements.

14. The thermal transfer assembly of Claim 17, wherein the set of heat-absorbing elements comprises a continuous fin array, the continuous fin array including multiple alternating ridges and troughs extending along a length of the continuous fin array, and wherein the internal flow channel is arranged in a serpentine path in alignment with the continuous fin array.

15. A sealed cooling enclosure, comprising:
a housing defining an enclosed volume;
a thermal transfer plate positioned to form at least a portion of a boundary of the enclosed volume, the thermal transfer plate having a first surface facing outward from the enclosed volume and configured to thermally couple with a heat-generating component, and a second surface opposite the first surface and facing inward toward the enclosed volume;
a continuous fin array coupled to the thermal transfer plate and disposed within the enclosed volume, the continuous fin array including a series of alternating ridges and troughs extending along a length of the continuous fin array, wherein the continuous fin array is configured to absorb heat from an environment of the enclosed volume; and
an internal flow channel defined at least in part by a hollow internal cavity of the continuous fin array, the internal flow channel being configured to direct a coolant medium through the continuous fin array to transfer heat away from the continuous fin array.
